Europäisches Patentamt

European Patent Office

Office européen des brevets

(11) Publication number: **0 507 388 A2**

# EUROPEAN PATENT APPLICATION

(21) Application number: **92200871.9**

(22) Date of filing: **27.03.92**

(51) Int. Cl.5: **H03F 3/45**

(30) Priority: **02.04.91 EP 91200759**

(43) Date of publication of application:
**07.10.92 Bulletin 92/41**

(84) Designated Contracting States:
**DE FR GB IT NL**

(71) Applicant: **N.V. Philips' Gloeilampenfabrieken**
**Groenewoudseweg 1**
**NL-5621 BA Eindhoven(NL)**

(72) Inventor: **Blanken, Pieter Gerrit**
**c/o INT. OCTROOIBUREAU B.V., Prof.**
**Holstlaan 6**
**NL-5656 AA Eindhoven(NL)**

(74) Representative: **Schoonheijm, Harry Barend et al**
**INTERNATIONAAL OCTROOIBUREAU B.V.**
**Prof.Holstlaan 6**
**NL-5656 AA Eindhoven(NL)**

(54) **Differential amplifier with signal-dependent quiescent current control.**

(57) Differential amplifier with signal-dependent quiescent current control, comprising:
- a first ($T_1$) and a second ($T_2$) transistor of the same conductivity type for conducting a first ($I_1$) and a second ($I_2$) current respectively, the two transistors comprising each a control electrode coupled to a first (6) and a second (8) input terminal respectively, for feeding an input signal, a first main electrode coupled to a common terminal (3),
- converting means (10A, 10B) for converting the first and the second current to a measuring current in response to the first and the second current,
- comparing means comprising a control output terminal (11) for presenting a signal ($I_S$) in response to the difference between the measuring current and the reference current ($2I_Q$) of a reference current source (14),
- a controllable quiescent current source (4) coupled to the common terminal (3) for presenting a quiescent current ($I_O$) at the common terminal and having, coupled to the control output terminal (11), a control input (5) for controlling the quiescent current ($I_O$),
whilst the converting means comprise:
- a first/second current generator (10A/10B) for generating a first/second derived current ($I_A/I_B$) which decreases if the first second current ($I_1/I_2$) increases and vice versa,

- combining means (11) for generating the measuring current by adding together the first ($I_A$) and second ($I_B$) derived currents.

Due to the inverse characteristic of the first/second current generator, the measuring current will be increasingly more dominated by the smaller of the first and second currents in the event of an increasing input signal, so that the minimum value of the smaller current will be determined by the reference current. Generating the first and second derived currents and combining them to the measuring current is a continuous process and can therefore react fast to amplitude variations in the first and second currents.

FIG.1a

The invention relates to a differential amplifier with signal-dependent quiescent current control, comprising:
- a first and a second input terminal for feeding an input signal,
- a first and a second output terminal for presenting an output signal,
- a common terminal,
- a first and a second transistor of the same conductivity type for conducting a first and a second current respectively, the two transistors comprising each a control electrode coupled to the first and the second input terminal respectively, a first main electrode coupled to the common terminal and a second main electrode coupled to the first and the second output terminal respectively,
- converting means for converting the first and the second current to a measuring current in response to, in essence, the smaller of the first and the second current,
- comparing means comprising a control output terminal for presenting a signal in response to the difference between the measuring current and the reference current of a reference current source,
- a controllable quiescent current source coupled to the common terminal for presenting a quiescent current at the common terminal and having a control input for controlling the quiescent current,
- coupling means for coupling the control output terminal of the comparing means to the control input of the quiescent current source.

In the present description and in the claims the control electrode, the first main electrode and the second main electrode are the base, emitter and collector respectively, of a bipolar transistor, or the gate, source and drain respectively, of a unipolar transistor.

A differential amplifier mentioned in the opening paragraph is known from United States Patent US 4,628,280. Differential amplifiers of this type are also known in the English professional literature as adaptive bias or dynamic bias amplifiers. In the known differential amplifier the quiescent current for the first and second transistors is controlled in such a way that the current flowing through the transistor that conducts less does not drop below a predetermined minimum. On the one hand, this achieves that the quiescent current is increased in the event of an increasing signal difference at the input terminals, so that the slew rate of the differential amplifier rises. On the other hand, this avoids that the less-conductive of the first and second transistors is turned off in the event of an ever-increasing signal difference at the input terminals. For this purpose, the known differential amplifier comprises converting means in which the magnitude of the first and second currents is measured and in which the smaller of the first and second currents is selected with a selection circuit and converted to a measuring current. Thereafter, the measuring current is compared with a reference current. If the measuring current differs from the reference current, the controllable quiescent current source is adjusted until the measuring current, *i.e.* the smaller of the first and second currents, is dual to the reference current.

A drawback of this known differential amplifier is that the selection circuit, for determining the smaller of the first and second currents, comprises transistors which are turned off, for example, if the first current exceeds the second current. If, subsequently, the first current drops below the second current, the transistors are again switched on. However, this switching on takes time and restricts the rate at which the first and second currents may change relative to one another and thus also restricts the highest input signal frequency that can be processed by the differential amplifier without a disturbance or distortion.

It is an object of the invention to provide a differential amplifier with a signal-dependent quiescent current control of aforementioned type having a higher permissible input signal frequency.

A differential amplifier of the type mentioned in the opening paragraph is characterized according to the invention, in that the converting means comprise:
- a first current generator for generating a first derived current which decreases if the first current increases and *vice versa*,
- a second current generator for generating a second derived current which decreases if the second current increases and *vice versa*,
- combining means for generating the measuring current by adding together the first and second derived currents.

Due to the inverse characteristic of the first and the second current generator, the measuring current will be increasingly more dominated by the smaller of the first and second currents in the event of an increasing input signal, so that the minimum value of the smaller current will be determined by the reference current. However, generating the first and second derived currents and combining them to the measuring current is a continuous process and can therefore react fast to amplitude variations in the first and second currents.

It should be observed that United States Patent US 4,797,629 has disclosed a differential amplifier comprising a controllable quiescent current source, wherein the quiescent current is also influenced by two derived currents having inverse-characteristics. In this known differential amplifier, however, the derived currents are not added together to form a measuring current and subsequently compared to a reference current. As a result, it is not avoided that the less conductive of the first and second transistors is turned off in the event of an ever-increasing signal difference at the input terminals.

The first and the second current generator having inverse-characteristics may be realised in various ways. A first embodiment of a differential amplifier according to the invention is characterized, in that the first and the second current generator respectively, both comprise:

- a measuring transistor of a conductivity type opposite to that of the first and second transistors, comprising a second main electrode coupled to the control output terminal, a control electrode coupled to the control electrode of the first or second transistor respectively, and a first main electrode coupled to the first main electrode of the first and the second transistor respectively.

The current flowing through the first and second transistors is measured with a measuring transistor of an opposite conductivity type, whose junction formed by the control electrode and the first main electrode is connected in parallel with the corresponding junction of the first and second transistors. A current increase through the first or second transistor will be accompanied by a current decrease in the associated measuring transistor.

It should be observed that United States Patent US 4,002,993 has disclosed in Fig. 3 a differential amplifier which comprises a controllable quiescent current source, in which also measuring transistors of opposite conductivity types are used. However, In this circuit the junctions are not connected in parallel with the junctions of the first and second transistors. In addition, in this circuit the second main electrodes of the measuring transistors are not coupled to a terminal that operates as a control output terminal.

A further first embodiment of a differential amplifier according to the invention is characterized, in that the first main electrode of the measuring transistor is connected to the first main electrode of the first or second transistor respectively, and in that the first and the second current generator respectively, further include:

- a third transistor of the same conductivity type as that of the first transistor, comprising a control electrode connected to the control electrode of the first or second transistor respectively, comprising a second main electrode coupled to a first supply terminal and comprising a first main electrode,
- a fourth transistor of a conductivity type opposite to that of the first transistor, comprising a control electrode, a first main electrode and a second main electrode, in which the first main electrode of the fourth transistor is connected to the first main electrode of the third transistor, the control electrode of the fourth transistor is connected to the control electrode of the measuring transistor, whilst the control electrode and the second main electrode of the fourth transistor are intercoupled at least as regards AC voltage,

- a bias current source coupled between the second main electrode of the fourth transistor and a second supply terminal.

The measuring transistor, third transistor, fourth transistor and the first or second transistor constitute a so-called translinear loop, whose principle is known, for example, from United States Patent 4,857,861. When bipolar transistors are used, this loop provides a hyperbolic relation between the derived current of the current generator and the first or second current which has a constant that is proportional to the square of the current supplied by the bias current source. When unipolar transistors are used, there is a linear relation between the square root of the derived current and the first or second current.

Another further first embodiment of a differential amplifier according to the invention is characterized, in that the control electrode of the measuring transistor is connected to the control electrode of the first and the second transistor respectively, and in that the first and the second current generator respectively, further include:

- a third transistor of a conductivity type opposite to that of the first transistor, comprising a control electrode, a first and a second main electrode, whilst the control electrode of the third transistor is connected to the first main electrode of the first and the second transistor respectively, and a second main electrode of the third transistor is coupled to a first supply terminal,
- a fourth and a fifth transistor of a conductivity type equal to that of the first transistor, the fourth and the fifth transistor comprising each a control electrode and a first and a second main electrode, whilst the first main electrode of the fourth transistor is connected to the first main electrode of the measuring transistor, the first main electrode of the fifth transistor is connected to the first main electrode of the third transistor, the control electrode of the fourth transistor is connected to the second main electrode of the fifth transistor and the control electrode of the fifth transistor is connected to the first main electrode of the fourth transistor, and the second main electrode of the fourth transistor is coupled to a second supply terminal,

- a bias current source coupled between the second main electrode of the fifth transistor and the second supply terminal.

The measuring transistor, third transistor, fifth transistor as well as the first or second transistor again form a translinear loop. This embodiment, however, permits a larger dynamic range at the first and second input terminals.

A second embodiment of a differential amplifier according to the invention is characterized, in that the first and the second current generator respectively, comprise each:

- a measuring resistor included in the first main electrode path of the first and the second transistor respectively, comprising a first resistor terminal coupled to the first main electrode of the first and the second transistor respectively, and including a second resistor terminal coupled to the common terminal,
- a measuring transistor of a conductivity type opposite to that of the first and second transistors, comprising a second main electrode coupled to the control output terminal, a control electrode coupled to the first resistor terminal and a first main electrode coupled to the second resistor terminal.

The current flowing through the first and second transistors is measured by means of a measuring resistor included in the emitter path of the first and second transistors. The voltage drop across the measuring resistor is measured by means of a measuring transistor of an opposite conductivity type, whose junction formed by the control electrode and the first main electrode is connected in parallel with the measuring resistor. The junction is arranged in such a way that a current increase through the first or second transistor is accompanied by a current decrease in the associated measuring transistor. In this embodiment the first and second transistors themselves do not form part of the current generators. This may be advantageous if, for example, the first and second transistors are not thermally coupled to the current generators.

A further, relatively simple second embodiment of a differential amplifier according to the invention is characterized, in that the first main electrode of the measuring transistor is connected to the second resistor terminal and in that the first and the second current generator respectively, further include:

- a third transistor of a conductivity type opposite to that of the first transistor, comprising a control electrode, a first and a second main electrode, whilst the control electrode of the third transistor is connected to the control electrode of the measuring transistor and the control electrode and the second main electrode of the third transistor are intercoupled at least as regards AC voltage,
- a bias current source coupled between the second main electrode of the third transistor and a supply terminal,
- a further resistor inserted between the first main electrode of the third transistor and the first resistor terminal.

Another further second embodiment of a differential amplifier according to the invention is characterized, in that the control electrode of the measuring transistor is connected to the first resistor terminal and in that the first and the second current generator respectively, additionally include:

- a further resistor,
- a third transistor of a conductivity type opposite to that of the first transistor, comprising a control electrode, a first and a second main electrode, whilst the control electrode of the third transistor is connected to the second resistor terminal and the first main electrode of the third transistor is connected via the further resistor to the first main electrode of the measuring transistor,
- a first bias current source coupled between the second main electrode of the third transistor and a first supply terminal,
- a second bias current source coupled between the first main electrode of the measuring transistor and a second supply terminal,
- a fourth transistor of the same conductivity type as that of the first transistor, comprising a control electrode, a first and a second main electrode which are coupled to the second main electrode of the third transistor, the first supply terminal and the first main electrode of the measuring transistor respectively.

This embodiment permits the first and second input terminals to have a larger dynamic range than the further second embodiment.

Yet another further second embodiment of a differential amplifier according to the invention is characterized, in that the first and the second current generator respectively, further include each:

- a further resistor inserted between the control electrode of the measuring transistor and the first resistor terminal,
- a third transistor of a conductivity type opposite to that of the first transistor, comprising a control electrode, a first and a second main electrode, whilst the control electrode of the third transistor is connected to the second resistor terminal and the first main electrode of the third transistor is connected to the first main electrode of the measuring transistor,
- a first bias current source connected between the second main electrode of the third transistor and a first supply terminal,

- a second bias current source connected between the first main electrode of the measuring transistor and a second supply terminal,
- a fourth transistor of the same conductivity type as that of the first transistor, comprising a control electrode and a first and a second main electrode, which are coupled to the second main electrode of the third transistor, the first supply terminal and the first main electrode of the measuring transistor respectively,
- a third bias current source connected between the control electrode of the measuring transistor and the first supply terminal.

This embodiment has a larger gain in the control circuit formed by the third and fourth transistors and therefore exhibits improved stability.

A third embodiment of a differential amplifier according to the invention is characterized, in that the first and the second current generator respectively, include each:

- a measuring transistor of a conductivity type equal to that of the first and second transistors, comprising a second main electrode coupled to the control output terminal, comprising a control electrode coupled to the first main electrode of the first and the second transistor respectively, and comprising a first main electrode coupled to the control electrode of the first and the second transistor respectively.

The current flowing through the first and the second transistor is measured with the aid of a measuring transistor of the same conductivity type, whose junction formed by the control electrode and the first main electrode is connected anti-parallel to the corresponding junction of the first and the second transistor. A current increase through the first or second transistor will be accompanied by a current decrease in the associated measuring transistor.

This embodiment makes it possible to use transistors of the same conductivity type, for which the conductivity type may be selected that is the most suitable for high frequencies for example.

A further third embodiment of a differential amplifier according to the invention is characterized, in that the first main electrode of the measuring transistor is connected to the control electrode of the first and the second transistor respectively, and in that the first and the second current generator respectively, further include each:

- a third and a fourth transistor of the same conductivity type as that of the first transistor, comprising each a control electrode, a first and a second main electrode, whilst the control electrode of the third transistor is connected to the second main electrode of the third transistor and to the control electrode of the measuring transistor, the second main electrode of the fourth transistor is connected to the control electrode of the fourth transistor and to the first main electrode of the third transistor and whilst the first main electrode of the fourth transistor is connected to the first main electrode of the first and the second transistor respectively,

- a bias current source connected between the second main electrode of the third transistor and a supply terminal.

The measuring transistor, third transistor, fourth transistor as well as the first or second transistor again form a translinear loop.

A still further third embodiment of a differential amplifier according to the invention is characterized, in that the third transistor, the fourth transistor as well as the bias current source of the first and the second current generator are common to the two current generators, whilst the control electrode of the third transistor is connected to the control electrode of the measuring transistor of both the first and the second current generator, and the first main electrode of the fourth transistor is connected to the common terminal.

This embodiment is pre-eminently suitable if the first main electrodes of the first and second transistors are connected direct to the common terminal. A saving on components may then be realised.

A fourth embodiment of a differential amplifier according to the invention is characterized, in that the first and the second current generator respectively, include each:

- a measuring resistor included in the first main electrode path of the first and the second transistor respectively, comprising a first resistor terminal coupled to the first main electrode of the first and the second transistor respectively, and a second resistor terminal coupled to the common terminal,

- a measuring transistor of a conductivity type equal to that of the first and second transistors, comprising a second main electrode coupled to the control output terminal, a control electrode coupled to the second resistor terminal and a first main electrode coupled to the first resistor terminal.

The current flowing through the first and second transistors is measured with the aid of a measuring resistor included in the emitter path of the first and second transistors. The voltage drop across the measuring resistor is measured by means of a measuring transistor of the same conductivity type, whose junction formed by the control electrode and the first main electrode is connected in parallel with the measuring resistor. The junction is connected in such a way that a current increase through the first or second transistor is accompanied by a current decrease in the associated measuring transistor. In this embodiment the first and second transistors themselves do not form part of the current generators. Consequently, their properties and/or thermal behaviour do not have any effect on the generation of the derived currents.

A further relatively simple fourth embodiment of a differential amplifier according to the invention is characterized, in that the first main electrode of the measuring transistor is connected to the first resistor terminal and in that the first and the second current generator respectively, further include each:
- a further resistor,
- a third transistor of the same conductivity type as that of the first transistor, comprising a control electrode, a first and a second main electrode, whilst the control electrode of the third transistor is connected to the second main electrode of the third transistor and to the control electrode of the measuring transistor, and whilst the first main electrode of the third transistor is connected to the second resistor terminal by way of the further resistor,
- a bias current source connected between the second main electrode of the third transistor and a supply terminal.

A still further fourth embodiment of a differential amplifier according to the invention is characterized, in that the third transistor, the further resistor and the bias current source of the first and the second current generator are common to the two current generators, whilst the control electrode of the third transistor is connected to the control electrode of the measuring transistor of both the first and the second current generator, and whilst the further resistor is connected to the common terminal.

This embodiment is pre-eminently suitable if the second resistor terminals of the measuring resistors are connected direct to the common terminal. A saving on components may then be realised.

A fifth embodiment of a differential amplifier according to the invention is characterized, in that the controllable quiescent current source is arranged as a transistor of a conductivity type equal to that of the first and second transistors, comprising a control electrode, a first and a second main electrode which are coupled to the control input, a supply terminal and the common terminal respectively.

The first transistor, the second transistor and the quiescent current source transistor form the basis of the differential amplifier and conduct the largest signal currents while there is a large control range. Since these transistors are of the same conductivity type, the conductivity type most suitable for high frequencies may be selected for them.

The invention will be further explained with reference to the appended drawing Figures, in which:

Fig. 1a shows an embodiment of a differential amplifier according to the invention, comprising bipolar transistors,

Fig. 1b shows an embodiment of a differential amplifier according to the invention, comprising unipolar transistors,

Fig. 2 shows a further detailed embodiment of the differential amplifier as shown in Fig. 1a,

Fig. 3 shows an embodiment of a differential amplifier according to the invention, comprising bipolar transistors,

Fig. 4 shows an embodiment of a differential amplifier according to the invention, comprising bipolar transistors,

Fig. 5 shows details of alternative circuits to be used in the differential amplifier according to the invention shown in Fig. 4,

Fig. 6 shows an embodiment of a differential amplifier according to the invention, comprising bipolar transistors,

Fig. 7 shows an embodiment of a differential amplifier according to the invention, comprising bipolar transistors,

Fig. 8 shows details of an alternative circuit to be used in the differential amplifier according to the invention shown in Figs. 6 and 7,

Fig. 9 shows an embodiment of a differential amplifier according to the invention, comprising bipolar transistors,

Fig. 10 shows an embodiment of a differential amplifier according to the invention, comprising bipolar transistors,

Fig. 11 shows an embodiment of a differential amplifier according to the invention, comprising bipolar transistors, and

Fig. 12 shows details of an alternative circuit to be used in the differential amplifier according to the invention shown in Figs. 10 and 11.

In these drawing Figures components having like functions or connotations have like reference characters.

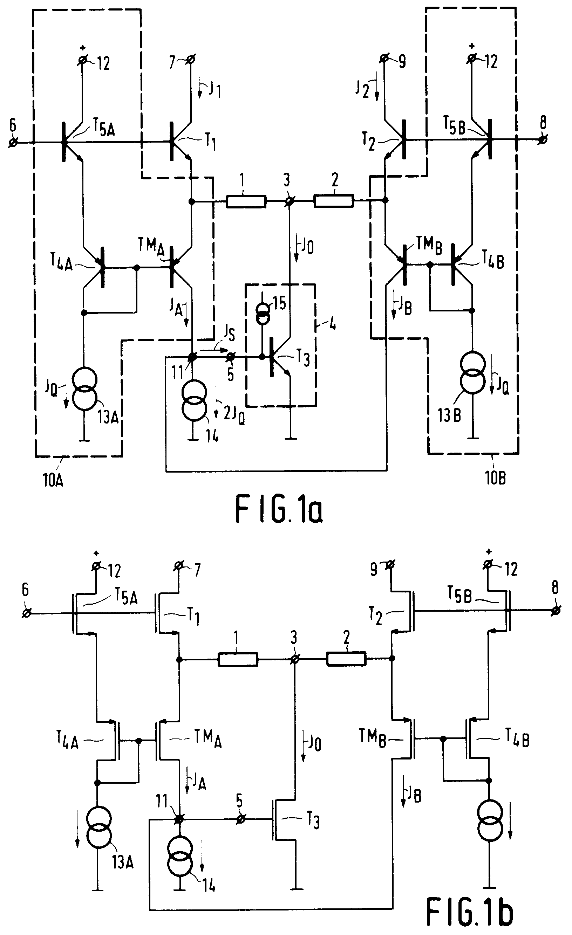

Fig. 1a. shows a differential amplifier with signal-dependent quiescent current control according to the invention, comprising bipolar transistors. The differential amplifier proper comprises the npn transistors $T_1$ and $T_2$, whose emitters, by way of an optional resistor 1, 2 respectively, are connected to a common terminal 3 which is supplied with a quiescent current $I_0$ a controllable quiescent cur-

rent source 4 which has a control input 5 for controlling the quiescent current $I_0$. In this embodiment the quiescent current source 4 is arranged as an npn transistor $T_3$, whose base, collector and emitter are connected to the control input 5, the common terminal 3 and a negative supply terminal considered to be connected to earth respectively. The quiescent current $I_0$ is biassed by means of a bias current source 15 which supplies a base current to transistor $T_3$. The base and collector of transistor $T_1$ are connected to an input terminal 6 and an output terminal 7 respectively. The base and collector of transistor $T_2$ are connected to an input terminal 8 and an output terminal 9 respectively. An input signal source (not shown) is connected to the input terminals 6, 8, which signal source causes a current $I_1$, $I_2$ to flow through the transistors $T_1$ and $T_2$ respectively, in a load (not shown) connected to the output terminals 7, 9. The maximum value of the currents $I_1$ and $I_2$ depends on the quiescent current $I_0$ which, as is known, determines the slew rate of the differential amplifier. A high slew rate asks for a high quiescent current $I_0$ which in turn causes a high undesired dissipation in the differential amplifier. In order to meet these contradicting requirements, the quiescent current $I_0$ is adapted to the instantaneous value of the currents $I_1$ and $I_2$. For this purpose, the current $I_1$ flowing through the transistor $T_1$ is measured by means of a current generator 10A which generates a current $I_A$ derived from the current $I_1$, which derived current $I_A$ decreases if $I_1$ increases and *vice versa*. The current $I_2$ flowing through transistor $T_2$ is measured by means of an identical current generator 10B which generates a current $I_B$ derived from the current $I_2$, which derived current $I_B$ decreases if $I_2$ increases and *vice versa*.

The current generator 10A comprises a pnp measuring transistor $TM_A$ whose base-emitter junction is connected in parallel with the base-emitter junction of transistor $T_1$ and whose collector is coupled to a control output terminal 11. Since the transistors $T_1$ and $TM_A$ are of opposite conductivity types, the derived current $I_A$ flowing through transistor $TM_A$ will decrease if the current $I_1$ flowing through transistor $T_1$ increases and *vice versa*. The emitter of transistor $TM_A$ is connected to the emitter of transistor $T_1$. The base of transistor $TM_A$ is connected to the base of a diode-arranged pnp transistor $T_{4A}$ whose emitter is connected to the emitter of an npn transistor $T_{5A}$ whose base is connected to the base of transistor $T_1$ and whose collector is connected to a positive supply terminal 12. A buffer stage having a unity-gain can be substituted for the connection between the base and collector of transistor $T_{4A}$. The collector of transistor $T_{4A}$ is connected to earth by way of a bias current source 13A which supplies a bias current $I_Q$. The transistors $T_{4A}$, $T_{5A}$ and the bias current source 13A form a level shifter which causes a shift to occur that is the sum of a pnp and an npn base-emitter junction. The current generator 10B comprises the measuring transistor $TM_B$ through which the derived measuring current $I_B$ flows, the transistors $T_{4B}$ and $T_{5B}$ and a bias current source 13B which likewise supplies a bias current $I_Q$. The components of current generator 10B are connected to the transistor $T_2$, supply terminal 12, control output terminal 11 and earth in like manner to that of transistor $T_1$, supply terminal 12, control output terminal 11 and earth in current generator 10A. The control output terminal 11 is further connected to earth by way of a reference current source 14 which supplies a reference current $2I_Q$ which is twice as large as that of the bias current sources 13A and 13B, but this is not a necessity.

The base-emitter junctions of the transistors $T_1$, $TM_A$, $T_{4A}$ and $T_{5A}$ constitute a translinear loop. The sum of the base-emitter voltages of the transistors $T_1$ and $TM_A$ is equal to the sum of the base-emitter voltages of the transistors $T_{5A}$ and $T_{4A}$. Due to the logarithmic relation between the base-emitter voltage of a transistor and the current flowing through the transistor, the product $I_1{}^*I_A$ of the current $I_1$ through transistor $T_1$ and the derived current $I_A$ through transistor $TM_A$ is proportional to the product $I_Q{}^*I_Q$ of the current $I_Q$ flowing through the transistors $T_{5A}$ and $T_{4A}$. There is a similar relation between the currents $I_2$, $I_B$ and $I_Q$: $I_2{}^*I_B \sim I_Q{}^*I_Q$. The derived currents $I_A$ and $I_B$ are thus inversely proportional to $I_1$ and $I_2$ respectively. In the control output terminal 11 the derived currents $I_A$ and $I_B$ are added together to form a measuring current $I_A + I_B$ and compared with the reference current $2I_Q$. The difference signal $I_S$ between the measuring current and the reference current flows from the control output terminal 11 to the control input 5 of the controllable quiescent current source 4. If the current $I_1$ is equal to $I_2$, the derived currents $I_A$ and $I_B$ are both equal to $I_Q$. In that case no difference signal $I_S$ will flow to the base of transistor $T_3$, so that the quiescent current $I_0$ is minimized. The currents $I_1$ and $I_2$ are then both equal to $I_Q + I_0/2$.

In the case of an increasing voltage difference on the input terminals 6, 8, for example the current $I_1$ becomes increasingly larger than the current $I_2$. The derived current $I_A$ becomes increasingly smaller than the derived current $I_B$, but will not become zero. The contribution of $I_A$ to the measuring current $I_A + I_B$ will eventually be negligibly small relative to the much larger derived current $I_B$. The difference current $I_S$ in the base of transistor $T_3$ then, in essence, depends on the derived current

$I_B$. Under these circumstances, the transistor $T_3$ produces a quiescent current, the greater part of which flowing through transistor $T_1$ and the minor part through transistor $T_2$. If the current gain of transistor $T_3$ is large, the derived current $I_B$ will be substantially equal to the reference current $2I_Q$. Since $I_2 \sim I_Q{}^*I_Q/I_B$, the current $I_2$ will reach a value which is half the quiescent current value. Conversely, if the current $I_2$ becomes increasingly larger than $I_1$, the current $I_1$ will reach half the quiescent current value. The smaller of the currents $I_1$ and $I_2$ will not become zero in the event of large input signals, whereas the minimum value can be fixed by the selection of the reference current $2I_Q$. A high current gain in the controllable quiescent current source 4 may also be realised by means of, for example, an additional emitter-follower connected in series to the base of transistor $T_3$.

The inverse relation between the currents $I_1$ and $I_A$ and between $I_2$ and $I_B$ may also be established in other ways than with the bipolar translinear loop. Fig. 1b shows a similar differential amplifier to Fig. 1a, but comprising unipolar transistors. The operation is completely analogous with the proviso that the relation between said currents can no longer be described as was done with respect to the bipolar differential amplifier. Nevertheless, it still holds that the currents $I_A$ and $I_B$ decrease if the currents $I_1$ and $I_2$ respectively, increase and *vice versa*. In the long run, again either of the currents $I_A$ and $I_B$ will be dominating and become equal to the reference current $2I_Q$. The systematic relation between the smallest current and the reference current is determined by the voltage/current characteristics of the unipolar transistors used.

For the bias current sources 13A, 13B and the reference current source 14 in the differential amplifiers shown in the Figs. 1a and 1b, it is also permitted to use resistors. This is especially favourable if the differential amplifier is structured with discrete components because this entails fewer components. The currents supplied by the thus structured bias current sources 13A, 13B and the reference current source 14 are not constant, it is true, but this is no objection and neither does it alter the fundamental operation of the signal-dependent quiescent current control. In the differential amplifier shown in Fig. 1a the reference current of the reference current source 14 may be determined on the basis of the base-emitter voltage of transistor $T_3$ and the resistance of the resistor which substitutes for the current source. For the bias current sources 13A and 13B the current is determined by the voltage on the input terminals 6 and 8, reduced by two base-emitter voltages and the resistance of the resistor which substitutes for the current source.

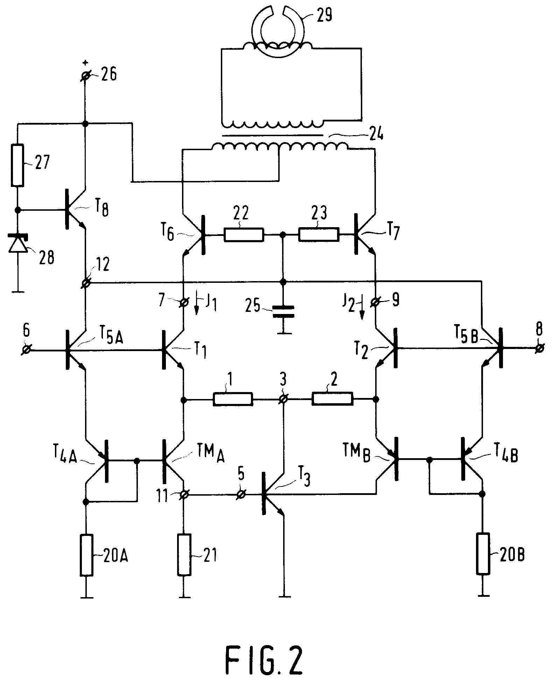

Fig. 2 shows an embodiment of a differential amplifier according to the invention which is largely identical with the differential amplifier as shown in Fig. 1a. The load on the output terminals 7, 9 is formed by a transformer 24 of which a primary winding is connected to the output terminals 7 and 9 respectively, by way of the emitter-collector paths of transistors $T_6$ and $T_7$. The bases of the transistors $T_6$ and $T_7$ are connected *via* series resistors 22 and 23 to the positive supply terminal 12 which is bypassed to earth by way of a capacitor 25. The supply to terminal 12 is provided by a transistor $T_8$ arranged as an emitter-follower, whose emitter is connected to supply terminal 12 and whose collector is connected to a supply terminal 26, and whose base is connected to a suitable voltage by means of a series combination of a resistor 27 and a Zener diode 28 between the supply terminal 26 and earth. The primary winding of transformer 24 has a centre tap connected to the supply terminal 26. The transformer 24 has a secondary winding to which a video head 29 is connected. The npn transistors $T_1$, $T_2$, $T_3$, $T_6$ and $T_7$ are of the BFQ18A type, the npn transistors $T_{5A}$, $T_{5B}$ and $T_8$ are of the BFS19 type, the pnp transistors $T_{4A}$, $T_{4B}$, $TM_A$ and $TM_B$ are of the BFT92 type. The collectors of the transistors $T_{4A}$ and $T_{4B}$ are connected to earth *via* respective resistors 20A and 20B of 390 ohms. The control output terminal 11 is connected to earth *via* a resistor 21 of 120 ohms. The resistors 1 and 2 are 4.7 ohms, the resistors 22 and 23 are 47 ohms and resistor 27 is 2200 ohms. The Zener diode 28 has a Zener voltage of about 5.1 volts and the supply voltage on voltage terminal 26 is about 13 volts relative to earth. The differential amplifier has a bandwidth of 200 MHz, is capable of supplying an output current with a 160 mA variation within 3 ns and dissipates 300 mW in a state of rest.

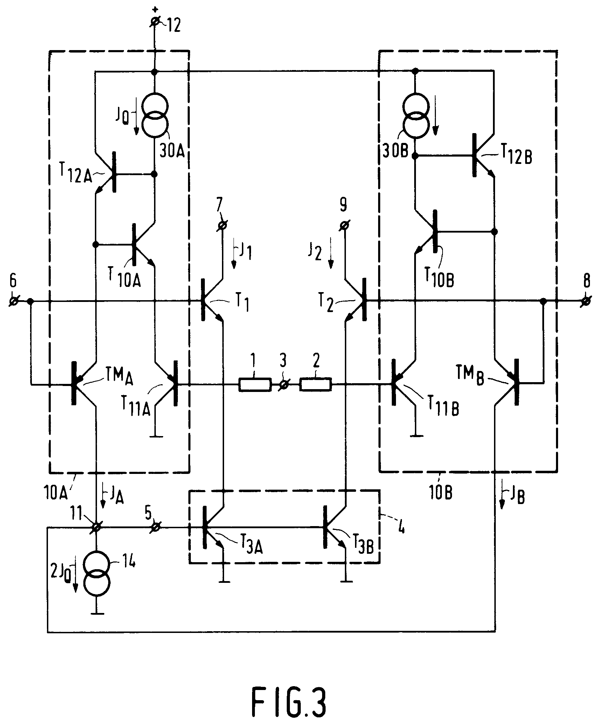

Fig. 3 shows a further embodiment of a differential amplifier according to the invention, in which the current generators 10A and 10B are structured differently from the differential amplifier shown in Fig. 1a and in which the controllable quiescent current source 4 comprises two transistors $T_{3A}$ and $T_{3B}$, whose base-emitter junctions are connected in parallel and whose collectors are connected to the emitters of the respective transistors $T_1$ and $T_2$. However, a single transistor $T_3$, whose collector is connected to the common terminal 3, as shown in Fig. 1a, is also possible. The current generator 10A comprises a pnp measuring transistor $TM_A$, whose base is connected to the base of transistor $T_1$, whose collector is coupled to the control output terminal 11 and whose emitter is connected to the base of an npn transistor $T_{10A}$. The collector of transistor $T_{10A}$ is connected to the positive supply terminal 12 by way of a bias current source 30A. The emitter of transistor $T_{10A}$ is connected to the emitter of a pnp transistor $T_{11A}$, whose collector is coupled to earth and whose base is connected to the emitter of transistor $T_1$. The current generator 10A further includes an npn transistor $T_{12A}$, whose base, emitter and collector are connected to the collector of transistor $T_{10A}$, the emitter of transistor $TM_A$ and the positive supply terminal 12 respectively. The transistors $T_1$, $T_{11A}$, $T_{10A}$ and $TM_A$ again constitute a translinear loop, whilst transistor $T_{12A}$ supplies the current $I_A$ of the positive supply terminal 12. The current generator 10B is identical with the current generator 10A and connected to transistor $T_2$ in like manner. The operation is further analogous to that of the differential amplifier shown in Fig. 1a and all the variants and options mentioned in that respect are applicable here too. This embodiment, however, permits a larger signal swing towards earth at the input terminals than the embodiment shown in Fig. 1a.

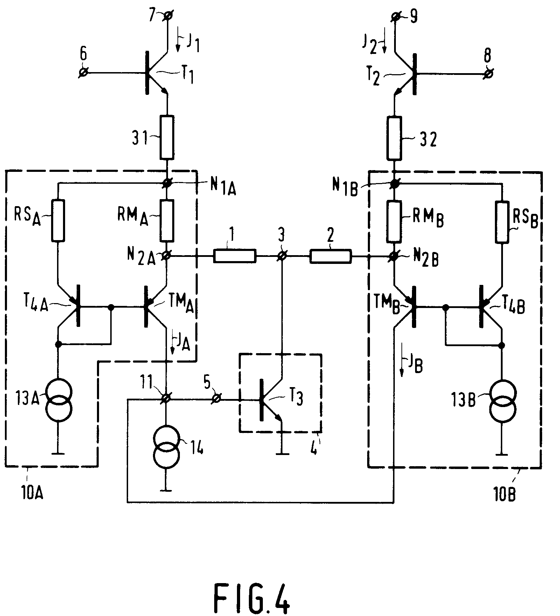

Fig. 4 shows an embodiment of a differential amplifier according to the invention, in which the current generators 10A and 10B are realised with the aid of a measuring resistor included in the emitter path of the transistors $T_1$ and $T_2$. The base-emitter junction of a pnp measuring transistor that generates the derived current is connected across the measuring resistor. By way of an optional resistor 31 the emitter of transistor $T_1$ is connected to a first resistor terminal $N_{1A}$ of a measuring resistor $RM_A$, of which a second resistor terminal $N_{2A}$ is connected to the common terminal 3 by way of the likewise optional resistor 1. The current generator 10A further includes a pnp measuring transistor $TM_A$, whose emitter is connected to the resistor terminal $N_{2A}$, whose collector is coupled to the control output terminal 11 and includes a diode-arranged pnp transistor $T_{4A}$, whose emitter is connected to the resistor terminal $N_{1A}$ via a series resistor $RS_A$, whose base is connected to the base of the measuring transistor $TM_A$ and whose collector is coupled to earth via a bias current source 13A. The current generator 10B is identical with current generator 10A and comprises like components which are connected in like fashion, whilst the transistor $T_2$ and the resistors 32 and 2 are substituted for transistor $T_1$ and the resistors 31 and 1. The differential amplifier further includes a controllable quiescent current source 4 and a reference current source 14 which are connected and arranged in like fashion to the one shown in Fig. 1a. The bias current source 13A, the transistor $T_{4A}$ and the series resistor $RS_A$ together constitute a level shifter which makes a coupling possible between the base of the measuring transistor $TM_A$ and the resistor terminal $N_{1A}$. The operation of the differential amplifier is further analogous to that of the differential amplifier shown in Fig. 1a and all the variants and options mentioned there are applicable here too.

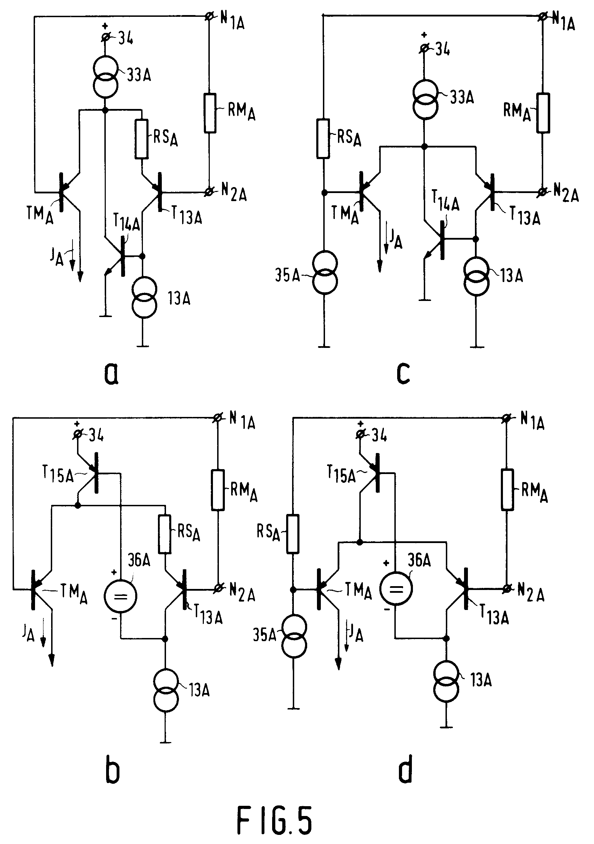

Fig. 5 shows four alternative current generators which may substitute for the current generators 10A and 10B of the differential amplifier shown in Fig. 4. The components are only shown for the current generator 10A; the other current generator 10B is identical. In Fig. 5a the base of the pnp measuring transistor $TM_A$ is connected to the resistor terminal $N_{1A}$ whilst the emitter is connected via a series resistor $RS_A$ to the emitter of a pnp transistor $T_{13A}$, whose base is connected to the resistor terminal $N_{2A}$. The collector of transistor $T_{13A}$ is connected to earth via the bias current source 13A. The emitter of the measuring transistor $TM_A$ is connected to a positive supply terminal 34 via a bias current source 33A. An npn transistor $T_{14A}$ whose base is connected to the collector of transistor $T_{13A}$, whose emitter is connected to earth and whose collector is connected to the emitter of the measuring transistor $TM_A$, stabilizes the operating point of transistor $T_{13A}$. In Fig. 5b the transistor $T_{14A}$ and the bias current source 33A are replaced by a pnp transistor $T_{15A}$ whose emitter is connected to the positive supply terminal 34, whose collector is connected to the emitter of the measuring transistor $TM_A$ and whose base is connected to the collector of transistor $T_{13A}$ via a level shifter 36A. The current generators of the Figs. 5c and 5d differ from those shown in Figs. 5a and 5b in the way that the series resistor $RS_A$ is not included in the emitter path of transistor $T_{13A}$ but inserted between the resistor terminal $N_{1A}$ and the base of the measuring transistor $TM_A$ and that this base is further connected to earth via a bias current source 35A. This renders the gain of the loop formed by the transistors $T_{13A}$, $T_{14A}$ or $T_{13A}$, $T_{15A}$ higher and provides a more stable adjustment of the transistor $T_{13A}$.

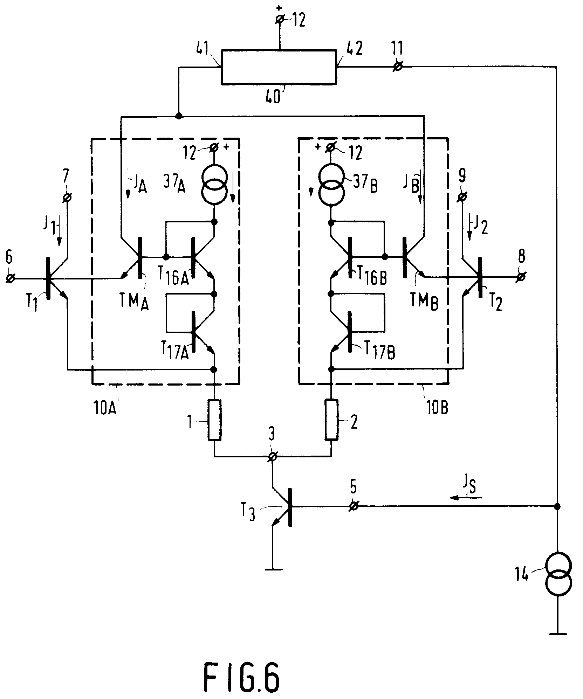

Fig. 6 shows a differential amplifier according to the invention in which the current generators 10A and 10B comprise a measuring transistor of the same conductivity type as the associated transistor $T_1$ or $T_2$. The inverse relation between the currents $I_1$ and $I_2$ caused by the transistors $T_1$ and $T_2$, and the derived currents $I_A$ and $I_B$ is obtained by inversely connecting the base-emitter junctions of the measuring transistors via the base-emitter junctions of the associated transistors $T_1$ and $T_2$. The transistors $T_1$, $T_2$ and $T_3$, the optional resistors 1 and 2 and the reference current source 14 are connected in identical manner to that shown in the differential amplifier of Fig. 1a. The current generator 10A comprises an npn measuring transistor $TM_A$ whose emitter is connected to the base of transistor $T_1$ and whose collector is connected to an input 41 of a current mirror circuit 40. The base of the measuring transistor $TM_A$ is connected to the base of a diode-arranged npn transistor $T_{16A}$ whose collector is connected to the positive supply terminal 12 *via* a bias current source 37A and whose emitter is connected to a likewise diode-arranged npn transistor $T_{17A}$ whose emitter is connected to the emitter of the transistor $T_1$. The transistors $T_1$, $TM_A$, $T_{16A}$ and $T_{17A}$ again form a translinear loop. The current generator 10B is identical with current generator 10A. The derived current $I_B$ of the measuring transistor $TM_B$ is also applied to the input 41 of current mirror circuit 40. The sum of the derived currents $I_A$ and $I_B$ appears as an output 42 of the current mirror circuit 40 which is connected to the control output terminal 11. The operation of the differential amplifier is furthermore analogous to that of the differential amplifier shown in Fig. 1a and all the variants and options mentioned with respect to that drawing Figure are applicable here too.

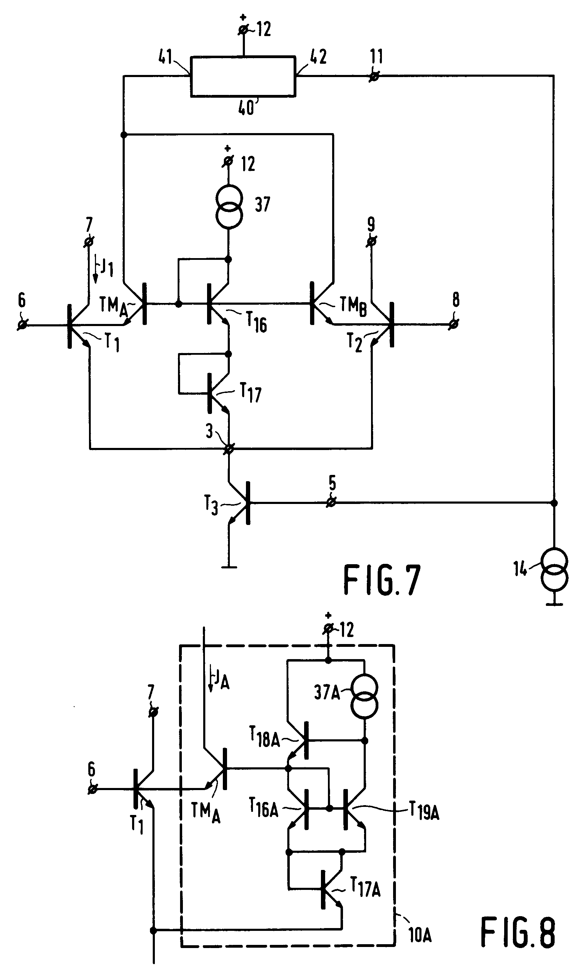

If the resistors 1 and 2 are omitted, the bias current sources 37A and 37B, the transistors $T_{16A}$ and $T_{16B}$ and the transistors $T_{17A}$ and $T_{17B}$ may be combined to a single bias current source 37, a single transistor $T_{16}$ and a single transistor $T_{17}$ by connecting all corresponding connections to one another as shown in Fig. 7.

Fig. 8 shows a variant for the current generators 10A and 10B in the differential amplifiers shown in Fig. 6 and Fig. 7. In this variant the bias current source 37A is not connected direct to the collector of transistor $T_{16A}$, but *via* the base-emitter junction of an npn transistor $T_{18A}$, whose collector is coupled to the positive supply terminal 12. The variant further includes an npn transistor $T_{19A}$, whose base-emitter junction is connected in parallel with that of the transistor $T_{16A}$ and whose collector is coupled to the base of transistor $T_{18A}$.

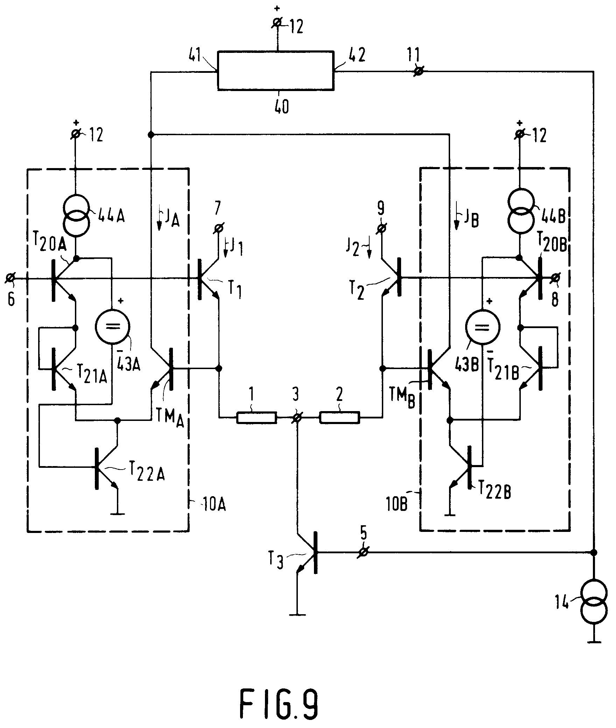

Fig. 9 shows a differential amplifier according to the invention, having an identical structure with that of the differential amplifier shown in Fig. 6. However, in the current generators 10A and 10B the base of the measuring transistor is now connected to the emitter of the associated transistor $T_1$ or $T_2$. The current generator 10A comprises the npn measuring transistor $TM_A$, and the npn transistors $T_{20A}$, $T_{21A}$, $T_{22A}$, a level shifter 43A and a bias current source 44A together forming the level shifter which makes a coupling possible between the emitter of the measuring transistor $TM_A$ and the base of transistor $T_1$. The base of transistor $T_{20A}$ is connected to the base of transistor $T_1$, the collector of transistor $T_{20A}$ is coupled to the positive supply terminal 12 *via* the bias current source 44A, and the emitter of transistor $T_{20A}$ is connected to the emitter of the measuring transistor $TM_A$ *via* the diode-arranged transistor $T_{21A}$. The junction of the emitters of the transistors $T_{21A}$ and $TM_A$ is connected to the collector of the transistor $T_{22A}$ whose emitter is connected to earth and whose base is coupled to the collector of transistor $T_{20A}$ *via* the level shifter 43A.

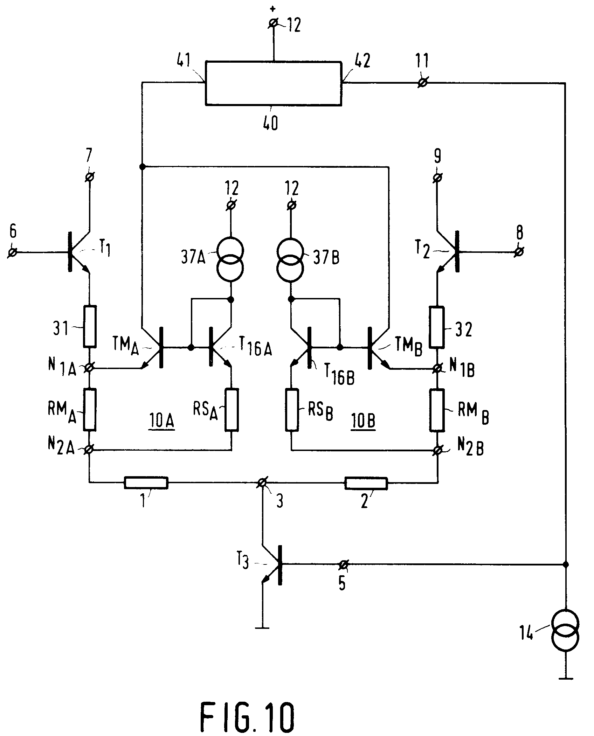

Fig. 10 shows a differential amplifier according to the invention in which the current generators 10A and 10B are realised with the aid of a measuring resistor included in the emitter path of the transistors $T_1$ and $T_2$. The base-emitter junction of an npn measuring transistor which generates the derived current is connected across the measuring resistor. The differential amplifier is, in essence, equal to that shown in Fig. 6. Different from this is the fact that in current generator 10A the emitter of the transistor $T_1$ is connected by way of an optional resistor 31 to the first resistor terminal $N_{1A}$ of the measuring resistor $RM_A$, whose second resistor terminal $N_{2A}$ is connected to the common terminal 3 by way of the likewise optional resistor 1. Furthermore, the emitter of transistor $T_{16A}$ is connected *via* a series resistor $RS_A$ to the resistor terminal $N_{2A}$. The current generator 10B is identical with the current generator 10A and comprises like components connected in like manner, the transistor $T_2$ and the resistors 32 and 2 substituting for the transistor $T_1$ and the resistors 31 and 1. The operation of the differential amplifier is again analogous to that of the differential amplifier shown in Fig. 1a and all the variants and options mentioned therein are applicable here too.

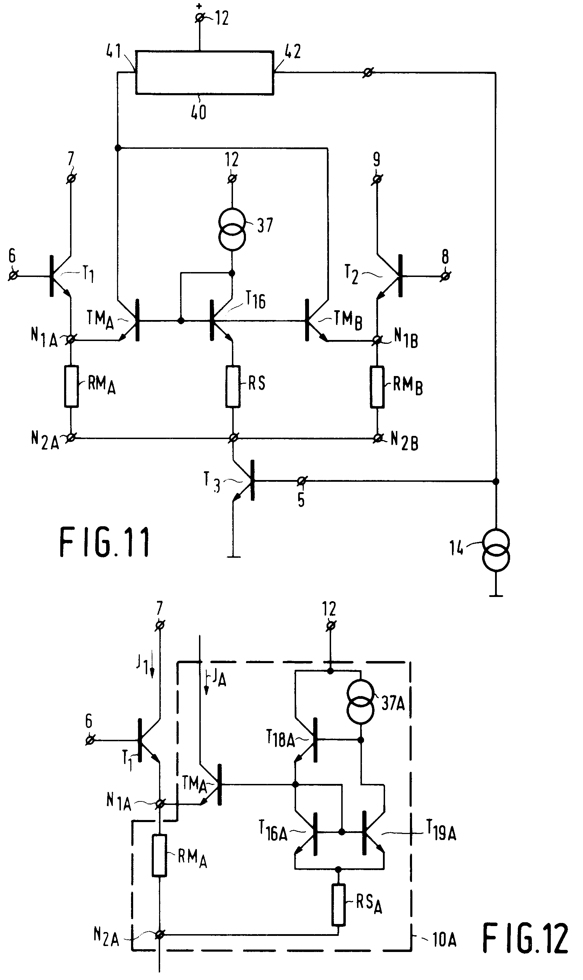

If the resistors 1 and 2 are omitted, the bias current sources 37A and 37B, the transistors $T_{16A}$ and $T_{16B}$ and the series resistors $RS_A$ and $RS_B$ may be combined to a single bias current source 37, a single transistor $T_{16}$ and a single series resistor RS by connecting all corresponding connections to one another. This is shown in Fig. 11.

Furthermore, it is possible to extend in the same manner the current generators included in the differential amplifiers shown in Figs. 10 and 11 by npn transistors $T_{18A}$ and $T_{19A}$ as shown in Fig. 8. This variant is shown in Fig. 12.

The invention is not restricted to the embodiments shown and discussed. As already stated with respect to Fig. 1b, also unipolar transistors may be used. A mixture of bipolar and unipolar transistors is likewise possible. In addition, reverse conductivity types may be selected for the transistors, in which case a supply voltage which is negative relative to earth is then to be fed to the relevant supply terminals. Furthermore, additional series resistors may be included as required in the emitter or source paths of all the transistors without harming the fundamental operation of the quiescent current control.

**Claims**

1. Differential amplifier with signal-dependent quiescent current control, comprising:
    - a first and a second input terminal for feeding an input signal,
    - a first and a second output terminal for presenting an output signal,
    - a common terminal,
    - a first and a second transistor of the same conductivity type for conducting a first and a second current respectively, the two transistors comprising each a control electrode coupled to the first and the second input terminal respectively, a first main electrode coupled to the common terminal and a second main electrode coupled to the first and the second output terminal respectively,
    - converting means for converting the first and the second current to a measuring current in response to, in essence, the smaller of the first and the second current,
    - comparing means comprising a control output terminal for presenting a signal in response to the difference between the measuring current and the reference current of a reference current source,
    - a controllable quiescent current source coupled to the common terminal for presenting a quiescent current at the common terminal and having a control input for controlling the quiescent current,
    - coupling means for coupling the control output terminal of the comparing means to the control input of the quiescent current source, characterized in that the converting means comprise:
    - a first current generator for generating a first derived current which decreases if the first current increases and *vice versa*,
    - a second current generator for generating a second derived current which decreases if the second current increases and *vice versa*,
    - combining means for generating the measuring current by adding together the first and second derived currents.

2. Differential amplifier as claimed in Claim 1, characterized in that the first and the second current generator respectively, both comprise:
    - a measuring transistor of a conductivity type opposite to that of the first and second transistors, comprising a second main electrode coupled to the control output terminal, a control electrode coupled to the control electrode of the first or second transistor respectively, and a first main electrode coupled to the first main electrode of the first and the second transistor respectively.

3. Differential amplifier as claimed in Claim 2, characterized in that the first main electrode of the measuring transistor is connected to the first main electrode of the first or second transistor respectively, and in that the first and the second current generator respectively, further include:
    - a third transistor of the same conductivity type as that of the first transistor, comprising a control electrode connected to the control electrode of the first or second transistor respectively, comprising a second main electrode coupled to a first supply terminal and comprising a first main electrode,
    - a fourth transistor of a conductivity type opposite to that of the first transistor, comprising a control electrode, a first main electrode and a second main electrode, in which the first main electrode of the fourth transistor is connected to the first main electrode of the third transistor, the control electrode of the fourth transistor is connected to the control electrode of the measuring transistor, whilst the control electrode and the second main electrode of the fourth transistor are intercoupled at least as regards AC voltage,
    - a bias current source coupled between the second main electrode of the fourth transistor and a second supply terminal.

4. Differential amplifier as claimed in Claim 2, characterised in that the control electrode of the measuring transistor is connected to the control electrode of the first and the second transistor respectively, and in that the first and the second current generator respectively, further include:
    - a third transistor of a conductivity type opposite to that of the first transistor, comprising a control electrode, a first and a second main electrode, whilst the control electrode of the third transistor is connected to the first main electrode of the first and the second transistor respectively, and a second main electrode of the third transistor is coupled to a first supply terminal,
    - a fourth and a fifth transistor of a conductivity type equal to that of the first transistor, the fourth and the fifth transistor comprising each a control electrode and a first and a second main electrode, whilst the first main electrode of the fourth transistor is connected to the first main electrode of the measuring transistor, the first main electrode of the fifth transistor is connected to the first main electrode of the third transistor, the control electrode of the fourth transistor is connected to the second main electrode of the fifth transistor and the control electrode of the fifth transistor is connected to the first main electrode of the fourth transistor, and the second main electrode of the fourth transistor is coupled to a second supply terminal,
- a bias current source coupled between the second main electrode of the fifth transistor and the second supply terminal.

5. Differential amplifier as claimed in Claim 1, characterized in that the first and the second current generator respectively, comprise each:
- a measuring resistor included in the first main electrode path of the first and the second transistor respectively, comprising a first resistor terminal coupled to the first main electrode of the first and the second transistor respectively, and including a second resistor terminal coupled to the common terminal,
- a measuring transistor of a conductivity type opposite to that of the first and second transistors, comprising a second main electrode coupled to the control output terminal, a control electrode coupled to the first resistor terminal and a first main electrode coupled to the second resistor terminal.

6. Differential amplifier as claimed in Claim 5, characterised in that the first main electrode of the measuring transistor is connected to the second resistor terminal and in that the first and the second current generator respectively, further include:
- a third transistor of a conductivity type opposite to that of the first transistor, comprising a control electrode, a first and a second main electrode, whilst the control electrode of the third transistor is connected to the control electrode of the measuring transistor and the control electrode and the second main electrode of the third transistor are intercoupled at least as regards AC voltage,
- a bias current source coupled between the second main electrode of the third transistor and a supply terminal,
- a further resistor inserted between the first main electrode of the third transistor and the first resistor terminal.

7. Differential amplifier as claimed in Claim 5, characterized, in that the control electrode of the measuring transistor is connected to the first resistor terminal and in that the first and the second current generator respectively, additionally include:
- a further resistor,
- a third transistor of a conductivity type opposite to that of the first transistor, comprising a control electrode, a first and a second main electrode, whilst the control electrode of the third transistor is connected to the second resistor terminal and the first main electrode of the third transistor is connected *via* the further resistor to the first main electrode of the measuring transistor,
- a first bias current source coupled between the second main electrode of the third transistor and a first supply terminal,
- a second bias current source coupled between the first main electrode of the measuring transistor and a second supply terminal,
- a fourth transistor of the same conductivity type as that of the first transistor, comprising a control electrode and a first and a second main electrode which are coupled to the second main electrode of the third transistor, the first supply terminal and the first main electrode of the measuring transistor respectively.

8. Differential amplifier as claimed in Claim 5, characterized in that the first and the second current generator respectively, further include each:
- a further resistor inserted between the control electrode of the measuring transistor and the first resistor terminal,
- a third transistor of a conductivity type opposite to that of the first transistor, comprising a control electrode, a first and a second main electrode, whilst the control electrode of the third transistor is connected to the second resistor terminal and the first main electrode of the third transistor is connected to the first main electrode of the measuring transistor,
- a first bias current source connected between the second main electrode of the third transistor and a first supply terminal,

- a second bias current source connected between the first main electrode of the measuring transistor and a second supply terminal,

- a fourth transistor of the same conductivity type as that of the first transistor, comprising a control electrode and a first and a second main electrode, which are coupled to the second main electrode of the third transistor, the first supply terminal and the first main electrode of the measuring transistor respectively,

- a third bias current source connected between the control electrode of the measuring transistor and the first supply terminal.

9. Differential amplifier as claimed in Claim 1, characterized in that the first and the second current generator respectively, include each:
    - a measuring transistor of a conductivity type equal to that of the first and second transistors, comprising a second main electrode coupled to the control output terminal, comprising a control electrode coupled to the first main electrode of the first and the second transistor respectively, and comprising a first main electrode coupled to the control electrode of the first and the second transistor respectively.

10. Differential amplifier as claimed in Claim 9, characterized in that the first main electrode of the measuring transistor is connected to the control electrode of the first and the second transistor respectively, and in that the first and the second current generator respectively, further include each:
    - a third and a fourth transistor of the same conductivity type as that of the first transistor, comprising each a control electrode, a first and a second main electrode, whilst the control electrode of the third transistor is connected to the second main electrode of the third transistor and to the control electrode of the measuring transistor, the second main electrode of the fourth transistor is connected to the control electrode of the fourth transistor and to the first main electrode of the third transistor and whilst the first main electrode of the fourth transistor is connected to the first main electrode of the first and the second transistor respectively,

- a bias current source connected between the second main electrode of the third transistor and a supply terminal.

11. Differential amplifier as claimed in Claim 10, characterized in that the third transistor, the fourth transistor as well as the bias current source of the first and the second current generator common to the two current generators, whilst the control electrode of the third transistor is connected to the control electrode of the measuring transistor of both the first and the second current generator, and the first main electrode of the fourth transistor is connected to the common terminal.

12. Differential amplifier as claimed in Claim 1, characterized in that the first and the second current generator respectively, include each:
    - a measuring resistor included in the first main electrode path of the first and the second transistor respectively, comprising a first resistor terminal coupled to the first main electrode of the first and the second transistor respectively, and a second resistor terminal coupled to the common terminal,
    - a measuring transistor of a conductivity type equal to that of the first and second transistors, comprising a second main electrode coupled to the control output terminal, a control electrode coupled to the second resistor terminal and a first main electrode coupled to the first resistor terminal.

13. Differential amplifier as claimed in Claim 12, characterized in that the first main electrode of the measuring transistor is connected to the first resistor terminal and in that the first and the second current generator respectively, further include each:
    - a further resistor,
    - a third transistor of the same conductivity type as that of the first transistor, comprising a control electrode, a first and a second main electrode, whilst the control electrode of the third transistor is connected to the second main electrode of the third transistor and to the control electrode of the measuring transistor, and whilst the first main electrode of the third transistor is connected to the second resistor terminal by way of the further resistor,
    - a bias current source connected between the second main electrode of the third transistor and a supply terminal.

**14.** Differential amplifier as claimed in Claim 13, characterized in that the third transistor, the further resistor and the bias current source of the first and the second current generator are common to the two current generators, whilst the control electrode of the third transistor is connected to the control electrode of the measuring transistor of both the first and the second current generator, and whilst the further resistor is connected to the common terminal.

**15.** Differential amplifier as claimed in any preceding Claim, characterized in that the controllable quiescent current source is arranged as a transistor of a conductivity type equal to that of the first and second transistors, comprising a control electrode, a first and a second main electrode which are coupled to the control input, a supply terminal and the common terminal respectively.

**16.** Differential amplifier as claimed in Claim 15, characterized in that the reference current source is a resistor.

**17.** Differential amplifier as claimed in Claim 15 or 16, in so far dependent on Claims 3, 4, 6, 10, 11, 13 and 14, characterized in that the bias current source is a resistor.

**18.** Differential amplifier as claimed in Claim 15 or 16, in so far dependent on Claim 7, characterized in that the first and the second bias current source are resistors.

**19.** Differential amplifier as claimed in Claim 15 or 16, in so far dependent on Claim 8, characterized in that the first, the second and the third bias current source are resistors.

FIG.1a

FIG.1b

EP 0 507 388 A2

FIG.2

16

FIG.3

FIG.4

FIG.5

FIG.6

FIG.7

FIG.8

FIG.9

FIG.10

FIG.11

FIG.12